Europäisches Patentamt

European Patent Office

Office européen des brevets

(19)

(11) EP 1 187 098 B1

(12) EUROPÄISCHE PATENTSCHRIFT

(45) Veröffentlichungstag und Bekanntmachung des Hinweises auf die Patenterteilung:
11.10.2006 Patentblatt 2006/41

(51) Int Cl.:
*G10L 15/28* (2006.01)

(21) Anmeldenummer: 01119279.6

(22) Anmeldetag: 09.08.2001

(54) **Komprimieren von HMM-Prototypen**

Compression of HMM prototypes

Compression de prototypes de modèles de Markov cachés

(84) Benannte Vertragsstaaten:
DE ES FR GB IT

(30) Priorität: 06.09.2000 DE 10043946

(43) Veröffentlichungstag der Anmeldung:
13.03.2002 Patentblatt 2002/11

(73) Patentinhaber: SIEMENS
AKTIENGESELLSCHAFT
80333 München (DE)

(72) Erfinder: Hoege, Harald, Dr.
82131 Gauting (DE)

(56) Entgegenhaltungen:
EP-A- 0 709 826          US-A- 5 696 877

• BOURLARD H ET AL: "AUTO-ASSOCIATION BY MULTILAYER PERCEPTRONS AND SINGULAR VALUE DECOMPOSITION" BIOLOGICAL CYBERNETICS, SPRINGER VERLAG, BERLIN, DE, Bd. 59, Nr. 4/5, 1988, Seiten 291-294, XP000861877 ISSN: 0340-1200
• GOPINATH R A: "Maximum likelihood modeling with Gaussian distributions for classification" PROCEEDINGS OF THE 1998 IEEE INTERNATIONAL CONFERENCE ON ACOUSTICS, SPEECH AND SIGNAL PROCESSING, ICASSP '98 (CAT. NO. 98CH36181), PROCEEDINGS OF THE 1998 IEEE INTERNATIONAL CONFERENCE ON ACOUSTICS, SPEECH AND SIGNAL PROCESSING, SEATTLE, WA, USA, 12-1, Seiten 661-664 vol.2, XP002221813 1998, New York, NY, USA, IEEE, USA ISBN: 0-7803-4428-6

## Beschreibung

Die Erfindung betrifft ein Verfahren, ein Computerprogrammprodukt und einen Datenträger zum Komprimieren des von HMM-Prototypen in einem elektronischen Speicher benötigten Speicherplatzes sowie eine Anordnung zur automatischen Spracherkennung.

Sprachverarbeitungsverfahren sind beispielsweise aus US 6 029 135, US 5 732 388, DE 19636739 C1 und DE 19719381 C1 bekannt. Dabei wird natürliche gesprochene Sprache für die automatische Spracherkennung in letzter Zeit in der Regel durch sogenannte Hidden-Markov-Modelle (HMM) beschrieben. In Hidden-Markov-Modellen bezeichnet man mit Emissionswahrscheinlichkeit die Wahrscheinlichkeit dafür, dass das zu einer Klasse k gehörende Modell einen tatsächlich gesprochenen Laut bzw. eine tatsächlich gesprochene Lautfolge emittiert bzw. erzeugt. Die Klasse k kann dabei etwa ein Laut, eine Lautfolge bzw. ein Wort oder eine Wortfolge sein. Ein HMM-Prototyp ist der Mittelwert der zugehörigen Emissionswahrscheinlichkeitsverteilung. Sie werden aus Sprachaufnahmen gewonnen.

Die Prototypen ergeben sich aus den aufgenommenen Schallspektren nach Zerlegung in einzelne spektrale Merkmale und weiteren mathematischen Transformationen. Sie bestehen aus einer Anzahl von reellen Zahlen, den Komponenten, und können somit als Vektoren betrachtet werden. Die einzelnen Komponenten haben unterschiedliche Bedeutungen hinsichtlich der Identifizierung oder Zuordnung zu gewissen Lauten.

Hochperformante Erkenner sind auf Hidden-Markov-Modelle mit vielen Prototypen angewiesen. Der zur Abspeicherung der Prototypen benötigte Speicherplatz wächst in der Regel proportional zur Anzahl der Prototypen. Bei den derzeit besten Erkennern besteht ein Prototyp aus 10 bis 40 Komponenten. Jede Komponente wird mit 1 bis 4 Byte dargestellt.

Ganzwort-Erkenner zerlegen die Wörter in beliebige phonetische Einheiten, zu denen Prototypen erstellt werden. Sie kommen mit relativ wenigen Prototypen aus, etwa 1.000 bis 2.000 bei einem Wortschatz von 10 bis 50 Wörtern. Aufgrund des geringen Wortschatzes werden sie für Spezialanwendungen wie Zahlenerkennen oder Navigation in einem Menü eingesetzt.

Type-in-Erkenner ordnen Prototypen exakt einzelnen Lauten zu. Sie benötigen 4.000 bis 10.000 Prototypen, wobei jedem Laut 100 und mehr Prototypen zugeordnet werden können. Bei vielen Anwendungen ist die Verwendung eines type-in-Erkenners vorteilhaft, da dort der zu erkennende Wortschatz variabel gehalten werden kann.

Für einen type-in-Erkenner ergibt sich somit ein Speicherbedarf in der Größenordnung von 40 bis 1.600 Kilobyte. Insbesondere bei mobilen Consumer Endgeräten (z.B. Handys, Palm Pilots etc.) ist der verfügbare Speicherplatz sehr begrenzt, er liegt derzeit deutlich unter 100 Kilobyte, da die Kosten des Speichers und die vom Speicher verursachte Verlustleistung beschränkende Faktoren darstellen. Um hochperformante type-in-Erkenner auch für Consumer Endgeräte realisieren zu können, werden Verfahren benötigt, die eine drastische Komprimierung des Speicherbedarfs ermöglichen.

Aus Bourlard H. et al: "Auto-Association by Multilayer Perceptrons and Singular Value Decomposition", Biological Cybernetics, Springer Verlag, Berlin, Bd. 59, Nr. 4/5, 1988, Sei ten 291-294, ist ein Verfahren zum Komprimieren des von HMM-Prototypen in einem elektronischen Speicher benötigten Speicherplatzes bekannt, wobei HMM-Prototypen ($X^j$) vorgegeben werden, wobei die HMM-Prototypen ($X^j$) auf komprimierte HMM-Prototypen abgebildet werden, wobei ein neuronales Netz zum Abbilden der komprimierten HMM-Prototypen auf rekonstruierte HMM-Prototypen ($X'^j$) vorgesehen wird und wobei die komprimierten HMM-Prototypen und das neuronale Netz derart gewählt werden, dass der Abstand zwischen ($X^j$) und ($X'^j$) minimiert wird.

Aus Gopinath R. A.: "Maximum Likelihood Modeling with Gaussian Distributions for Classification", Procceedings of the 1998 IEEE International Conference on Acoustics, Speech and Signal Processing, Seattle, WA, USA, 12-1, Seiten 661-664, 1998, ist die Einbeziehung der Diskrimierungsfähigkeit der Prototypen-Komponenten in die Erstellung der HMM-Prototypen bekannt.

Aufgabe der Erfindung ist es, die Verringerung des von HMM-Prototypen in einem elektronischen Speicher benötigten Speicherplatzes durch Komprimieren zu ermöglichen.

Die Aufgabe wird durch ein Verfahren, ein Computerprogrammprodukt, einen Datenträger und einer Anordnung zum Komprimieren des von HMM-Prototypen in einem elektronischen Speicher benötigten Speicherplatzes gemäß der Ansprüche 1 und 3-5 gelöst.

Unter einem Computerprogrammprodukt wird das Computerprogramm als handelbares Produkt verstanden, in welcher Form auch im-mer, z.B. auf Papier, auf einem computerlesbaren Datenträger, über ein Netz verteilt etc.

Zunächst werden HMM-Prototypen $X^j$, (j = 1, ..., J), mit den Komponenten $X^j_k$, (k = 1, ..., N), vorgegeben, wobei J und N natürliche Zahlen sind. Typische Werte für J liegen, wie eingangs erwähnt, bei 1.000 oder 10.000, bei extremen Hochleistungserkennern auch bei 100.000. N liegt, wie oben erwähnt, in der Regel zwischen 10 und 40. Die HMM-Prototypen $X^j$ werden auf komprimierte HMM-Prototypen $Y^j$ abgebildet (codiert), (j = 1, ..., J), wobei $Y^j$ die Komponenten $Y^j_m$ hat, (m = 1, ..., M), wobei M eine natürliche Zahl ist. Die $Y^j$ sind auf geringen Speicherplatz hin optimierte Codierungen der $X^j$.

Nötig ist dann noch ein Decodierer, der die $X^j$ aus den $Y^j$ wenigstens näherungsweise rekonstruiert. Dazu wird ein Neuronales Netz (Decodierer) vorgesehen. Das Neuronale Netz bildet die $Y^j$ auf rekonstruierte HMM-Prototypen $X'^j$ ab (decodiert), (j = 1, ..., J), mit den Komponenten $X'^j_k$, (k = 1, ..., N). Die $X'^j$ sind die Rekonstruktionen der $X^j$.

Die komprimierten HMM-Prototypen $Y^j$ bilden somit zusammen mit dem Decodierer einen assoziativen Speicher für die HMM-Prototypen $X^j$.

Um eine optimale Komprimierung der HMM-Prototypen zu erreichen werden die $Y^j$ und der Decodierer derart gewählt,

- dass einerseits der Abstand zwischen $X^j$ und $X'^j$ minimiert wird, und
- dass andererseits der für die $Y^j$ und den Decodierer benötigte Speicherplatz in einem elektronischen Speicher minimiert wird.

Ein Erkenner, z.B. in einem Handy, braucht nach der erfindungsgemäßen Komprimierung nur noch die komprimierten HMM-Prototypen $Y^j$ und die Struktur und die Gewichte des Decodierers in Form eines Neuronalen Netzes abzuspeichern.

Um eine flexible Optimierung auch der Codierung zu ermöglichen, ist für die Abbildung (Codierung) der HMM-Prototypen $X^j$ auf die komprimierten HMM-Prototypen $Y^j$ ein Codierer vorgesehen. In einer vorteilhaften Weiterbildung der Erfindung kann als Codierer ein Neuronales Netz gewählt werden.

Zum Abspeichern der komprimierten HMM-Prototypen $Y^j$ sind lediglich Binärzahlen geeignet. Daher werden die erzeugten $Y^j_m$ in Binärzahlen $YQ^j_m$, (j = 1, ..., J), (m = 1, ..., M), umgewandelt. Wird der Codierer in Form eines Neuronalen Netzes ausgebildet, so sind die $Y^j_m$ reelle Zahlen. Es bietet sich dann die Zwischenschaltung eines Bit-Codierers an. Wird die Codierung nicht mit Hilfe eines Neuronalen Netzes durchgeführt, so kann eine unmittelbare Abbildungen der $X^j_k$ in Binärzahlen $Y^j_m$ erfolgen. Struktur und Parameter des als Decodierer arbeitenden Neuronalen Netzes werden derart gewählt, dass der Decodierer die Binärzahlen $YQ^j_m$ auf die $X'^j_k$ abbilden kann. Insgesamt werden Struktur und Parameter des Codierers, des Bit-Codierers und des Decodierers derart gewählt, dass die Binärzahlen $YQ^j_m$ aus möglichst wenigen Bits bestehen, um das Ziel einer optimalen Komprimierung und damit geringen Speicherbedarfs zu erreichen. Im Idealfall bestehen die $YQ^j_m$ jeweils nur aus 1 Bit.

Im Extremfall haben die $Y^j$ nur eine einzige Komponente, d.h. M = 1. Zusätzlich kann $YQ^j_1$ grundsätzlich auf 1 gesetzt werden. Dann brauchen die $Y^j$ selbst nicht mehr abgespeichert zu werden. Sie entsprechen dann schlicht jeweils einem Eingangsknoten des Neuronalen Netzes des Decodierers. Zum Rekonstruieren der HMM-Prototypen wird dem Neuronalen Netz des Decodierers lediglich die Nummer j des benötigten HMM-Prototypen vorgegeben.

Das Training des als Decodierer arbeitenden Neuronalen Netzes erfolgt mittels der $Y^j$ an den Eingängen und der $X^j$ an den Ausgängen. Die vom Neuronalen Netz erzeugten $X'^j$ werden auf ihren Abstand zu den $X^j$ hin untersucht. Der Abstand kann dabei beispielsweise ein Euklidisches Maß im Vektorraum der $X^j$ sein. Eine bessere Dekomprimierungsgenauigkeit wird erreicht, wenn zum Bestimmen des Abstands zwischen den $X^j$ und den $X'^j$ die Komponenten mit höherer Diskriminierungsfähigkeit stärker gewichtet werden. Die Diskriminierungsfähigkeit einer Komponente ist die Bedeutung dieser Komponente für die Entscheidung über die Zuordnung (Klassifizierung) eines aufgenommenen Lauts zu dem HMM-Prototypen, zu dem die Komponente gehört.

Weitere vorteilhafte Weiterbildungen der Erfindung sind in den Unteransprüchen gekennzeichnet.

Im folgenden wird die Erfindung anhand von Ausführungsbeispielen näher erläutert, die in den Figuren schematisch dargestellt sind. Gleiche Bezugsziffern in den einzelnen Figuren bezeichnen dabei gleiche Elemente. Im einzelnen zeigt:

Fig. 1    eine schematische Darstellung des Zusammenwirkens von Codierer und Decodierer zum Komprimieren von HMM-Prototypen;

Fig. 2    die Darstellung gemäß Fig. 2 einschließlich von Bit-Codierern; und

Fig. 3    eine Anordnung zur automatischen Spracherkennung, die komprimierte HMM-Prototypen verwendet.

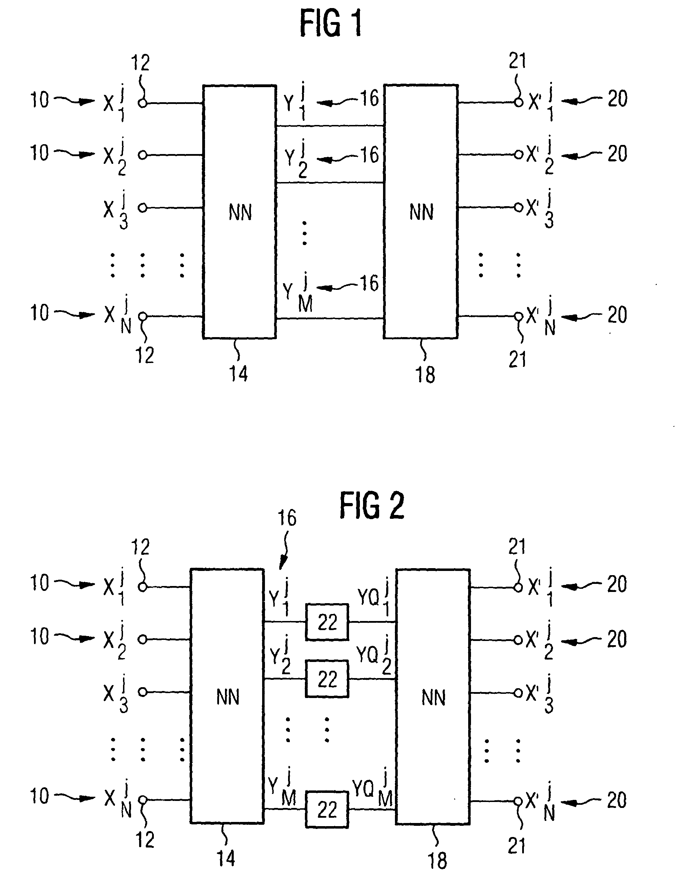

Fig. 1 zeigt einen HMM-Prototypen, der mit $X^j$ bezeichnet ist, j = 1, ..., J, wobei J eine natürliche Zahl ist. Die Komponenten $X^j_1$, $X^j_2$ bis $X^j_N$ von $X^j$ sind mit der Bezugsziffern 10 gekennzeichnet. Auch N ist eine natürliche Zahl. Die Komponenten werden an Eingänge 12 eines mit NN bezeichneten Neuronalen Netzes 14 angelegt. Das Neuronale Netz 14 arbeitet als Codierer. Es erzeugt komprimierte HMM-Prototypen $Y^j$, j= 1, ..., J, wobei J die oben erwähnte natürliche Zahl ist. $Y^j$ hat die Komponenten $Y^j_1$, $Y^j_2$ bis $Y^j_M$, wobei M eine natürliche Zahl ist. Die Komponenten $Y^j_m$ sind mit der Bezugsziffern 16 gekennzeichnet. Die durch das Neuronale Netz 14 erzeugten Komponenten $Y^j_m$ 16 sind reelle Zahlen. Ferner zeigt Fig. 1 ein zweites Neuronales Netz NN 18, das als Decodierer arbeitet. Es rekonstruiert HMM-Prototypen $X'^j$ mit den Komponenten $X'^j_1$, $X'^j_2$ bis $X'^j_N$, die mit der Bezugsziffer 20 bezeichnet sind an den Ausgangsknoten 21 des Neuronalen Netzes.

Das erfindungsgemäße Komprimierverfahren beruht auf einer Codierung und Decodierung auf der Basis von Neuronalen Netzen 14, 18. Jeder HMM-Prototypen $X^j$ wird zunächst einer Codierung mittels des Neuronalen Netzes 14 unterworfen. Dadurch wird der HMM-Prototyp $X^j$ auf einen komprimierten HMM-Prototypen $Y^j$ abgebildet. $X^j$ hat N Komponenten; $Y^j$ hat M Komponenten, wobei idR M wesentlich kleiner als N ist, um das Ziel der Komprimierung zu erreichen.

Die komprimierten HMM-Prototypen in Form der $Y^j$ können platzsparend in einem elektronischen Speicher abgelegt werden. Zum Durchführen von Spracherkennung bedarf es der Rekonstruktion der ursprünglichen HMM-Prototypen $X^j$. Dies geschieht mit Hilfe des Neuronalen Netzes 18. Mit Hilfe des Neuronalen Netzes 18 werden die komprimierten HMM-Prototypen $Y^j$ auf rekonstruierte HMM-Prototypen $X'^j$ abgebildet.

Fig. 1 zeigt somit ein autoassoziatives Netzwerk bzw. einen assoziativen Speicher.

Gängige Neuronale Netze, wie das Neuronale Netz 14, liefern als Ausgabe reelle Zahlen für die Komponenten der komprimierten HMM-Prototypen $Y^j_m$. Reelle Zahlen sind zum Abspeicherung in einem elektronischen Speicher nicht geeignet. Daher ist dem Codierer 14 noch einen Bit-Codierer 22 nachgeschaltet (siehe Fig. 2), der die reellen Werte $Y^j_m$ in Werte $YQ^j_m$ umwandelt. Der Bit-Codierer führt keine einfache Analog-Digital-Wandlung durch. Vielmehr kann mit seiner Hilfe geeignet gewählt werden, welchem reellen Wert welche Bit-Kombination zugeordnet werden soll und wie viele Bits verwendet werden sollen.

Das für die Decodierung vorzugsweise verwendete Neuronale Netz 18 ist ein Multilayer-Perzeptron (MLP), ein schichtorientiertes, vorwärtsgerichtetes (feed forward) Netz mit einer geeigneten Vermaschung zwischen den einzelnen Schichten. Als Aktivierungsfunktion wird die Sigmoidfunktion $S_c(x)$ oder der $\tanh(x)$ verwendet. Für eine hohe Decodierungsgenauigkeit muss die Anzahl der variablen Parameter ausreichend groß gewählt werden. Dies kann stets durch geeignete Wahl der Anzahl der Schichten bzw. durch eine geeignete Anzahl von Neuronen in den/der versteckten Schicht(en) erreicht werden. Andererseits erhöht eine große Anzahl von Neuronen bzw. versteckten Schichten den benötigten Speicherplatz und die zum Decodieren benötigte Rechenleistung. Im bevorzugten Ausführungsbeispiel wird daher für das Neuronale Netz nur eine einzige versteckte Schicht verwendet.

Das Neuronale Netz 14 für die Codierung kann beliebig komplex gewählt werden, da es nicht in dem zu minimierenden Speicherplatz abgespeichert werden muss.

Neben der Minimierung des Speicherbedarfs sollte die Abweichungen zwischen den $X^j$ und den $X'^j$ so gering wie möglich sein. Daher wird beim Training des Neuronalen Netzes 18 als Optimierungskriterium ein geeigneter Abstand zwischen $X^j$ und $X'^j$ gewählt. Der Abstand kann dabei beispielsweise ein Euklidisches Maß im Vektorraum der $X^j$ sein, d.h.

$$\left\| X^j - X'^j \right\| = \sum_{k=1}^{N} \left( X^j_k - X'^j_k \right)^2$$

Eine bessere Dekomprimierungsgenauigkeit wird erreicht, wenn zum Bestimmen des Abstands zwischen den $X^j$ und den $X'^j$ die Komponenten mit höherer Diskriminierungsfähigkeit stärker gewichtet werden. Die Diskriminierungsfähigkeit einer Komponente ist die Bedeutung dieser Komponente für die Entscheidung über die Zuordnung (Klassifizierung) eines aufgenommenen Lauts zu dem HMM-Prototypen, zu dem die Komponente gehört. Das eigentliche Ziel des Decodierens besteht schließlich nicht darin, das X' die Werte von X gut approximiert, sondern dass die Fehlerrate des Erkenners bei der automatischen Spracherkennung unter Verwendung der rekonstruierten HMM-Prototypen $X'^j$ im Vergleich zu den uncodierten HMM-Prototypen $X^j$ möglichst wenig steigt.

Bei Verwendung der sogenannten "linear discriminant analysis" (LDA) zum Erzeugen der HMM-Prototypen ausgehend von den aufgenommenen Sprachdaten sind die Komponenten $X^j_1,..., X^j_N$ nach ihrer Diskriminierungsfähigkeit geordnet. Daher ist eine gute Approximation der Komponenten für die Werte $X^j_k$ mit kleinem Index k wichtiger als für große Indizes k. Als Abstand wird daher im bevorzugten Ausführungsbeispiel die Funktionen verwendet:

$$\left\| X^j - X'^j \right\| = \sum_{k=1}^{N} a_k \left( X^j_k - X'^j_k \right)^2 ; \qquad a_1 \geq a_2 \geq ... \geq a_{N-1} \geq a_N > 0,$$

wobei $a_k$ mit steigendem k fallende Werte annimmt.

Das Training des als Decodierer arbeitenden Neuronalen Netzes 18 erfolgt mittels der $Y^j$ an den Eingängen und der $X^j$ an den Ausgängen. Die vom Neuronalen Netz erzeugten $X'^j$ werden auf ihren Abstand zu den $X^j$ hin untersucht und die Gewichte geeignet verändert, um die Abstände im Mittel zu reduzieren.

Nach der Optimierung können die komprimierten HMM-Prototypen $Y^j$ zusammen mit der Struktur und den während des Trainings bestimmten Gewichten des Neuronalen Netzes sowie deren Indizes abgespeichert werden.

Wird ein relativ einfaches Neuronales Netz 18 zum Decodieren verwendet, so muss die Information über die HMM-Prototypen $X^j$ im wesentlichen in den komprimierten HMM-Prototypen $Y^j$ gespeichert werden. Bei 4.000 bis 10.000 HMM-Prototypen $X^j$ eines type-in-Erkenners erhält man die gleiche Anzahl komprimierter HMM-Prototypen $Y^j$. Diese haben nun aber weniger Komponenten, z.B. nur 5 bis 20 Komponenten pro Prototyp, da M kleiner als N erreicht werden kann. Ferner hat jede dieser Komponenten weniger Bits, z.B. nur 2 bis 16 Bits. Daraus ergeben sich 5 bis 400 Kilobyte Speicherbedarf für die komprimierten HMM-Prototypen.

Der Speicherbedarf für das Neuronale Netz fällt für ein Netz mit nur einer versteckten Schicht dagegen kaum ins Gewicht.

Insgesamt kann mit dem beschriebenen Verfahren eine Kompression des Speicherbedarfs um einen Faktor 2 bis 4 erreicht werden.

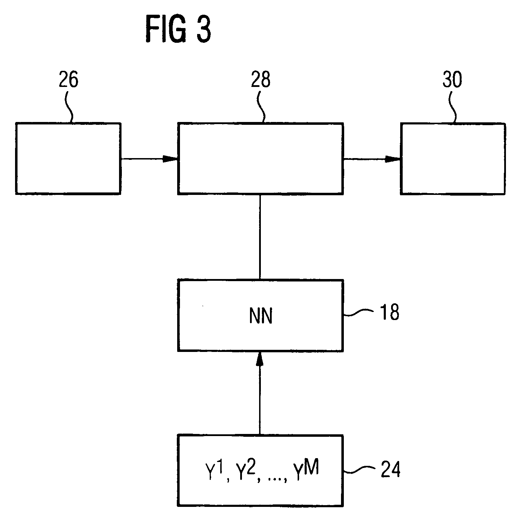

Fig. 3 zeigt eine Anordnung zur automatischen Spracherkennung z.B. in einem Handy. Sie enthält einen Speicher 24 zum Speichern von komprimierten HMM-Prototypen $Y^1$ bis $Y^J$. Ferner weist die Anordnung ein Neuronales Netz 18 zum Decodieren der komprimierten HMM-Prototypen, d.h. zum Rekonstruieren von HMM-Prototypen auf. Außerdem zeigt Fig. 3 eine Eingabe 26 für ein Sprachsignal, in der Regel eine transformierte Aufnahme des Schalls. Ein Erkenner 28 verwendet zum Erkennen des eingegebenen Sprachsignals als Prototypen die Ausgabewerte des Neuronalen Netzes 18. Die Ergebnisse des Erkenners 28 werden über eine Ausgabe 30 in Form eines Signals, das dem erkannten Sprachsignal entspricht, ausgegeben.

**Patentansprüche**

1. Verfahren zum Komprimieren von HMM-Prototypen,

   - wobei HMM-Prototypen ($X^j$) vorgegeben werden;
   - wobei die HMM-Prototypen ($X^j$) auf komprimierte HMM-Prototypen ($Y^j$) abgebildet werden;
   - wobei zum Abbilden der HMM-Prototypen ($X^j$) auf die komprimierten HMM-Prototypen ($Y^j$) ein Codierer (14) vorgesehen wird, welcher als Neuronales Netz ausgebildet ist;
   - wobei die komprimierten HMM-Prototypen ($Y^j$) Komponenten ($Y^j_m$, 16), (m = 1, ..., M), haben;
   - wobei die Komponenten ($Y^j_m$) durch einen Bit-Codierer (22) in Binärzahlen ($Yq^j_m$, 23), (j = 1, ..., J), (m = 1, ..., M), umgewandelt werden;
   - wobei ein Neuronales Netz (18) zum Abbilden der komprimierten HMM-Prototypen ($Y^j$) auf rekonstruierte HMM-Prototypen ($X^{'j}$) vorgesehen wird;
   - wobei Struktur und Parameter des Neuronalen Netzes (18) derart gewählt werden, dass das Neuronale Netz die Binärzahlen ($Yq^j_m$, 23) auf die rekonstruierten HMM-Prototypen ($X^{'j}_k$) abbilden kann;
   - wobei Struktur und Parameter des Neuronalen Netzes (14), des Bit-Codierers (22) und des Neuronalen Netzes (18) derart gewählt werden, dass die Binärzahlen ($Yq^j_m$, 23) aus möglichst wenigen Bits bestehen; und
   - wobei das Neuronale Netz (14) und das Neuronale Netz (18) derart gewählt werden, dass sowohl der Abstand zwischen ($X^j$) und ($X^{'j}$) als auch die Vektordimension der komprimierten HMM-Prototypen-($Y^j$) minimiert werden.

2. Verfahren nach mindestens einem der vorhergehenden Ansprüche,
   **dadurch gekennzeichnet,**
   **dass** zum Bestimmen des Abstands zwischen den ($X^j$) und den ($X^{'j}$) die Komponenten mit höherer Diskriminierungsfähigkeit stärker gewichtet werden.

3. Computerprogrammprodukt, das auf einem computergeeigneten 3 Medium speicherbar ist und computerlesbare Programmmittel umfasst, die es einem Computer ermöglichen, das Verfahren nach einem der Ansprüche 1 bis 2 auszuführen.

4. Datenträger, auf dem ein Computerprogramm gespeichert ist, das es einem Computer ermöglicht, durch einen Ladeprozess das Verfahren nach einem der Ansprüche 1 bis 2 auszuführen.

5. Anordnung,
   **dadurch gekennzeichnet,**
   **dass** sie eingerichtet ist, ein Verfahren nach einem der Ansprüche 1 bis 2 auszuführen.

**Claims**

1. Method for compressing HMM prototypes,

   - in which HMM prototypes ($X^j$) are prescribed;
   - in which the HMM prototypes ($X^j$) are mapped onto compressed HMM prototypes ($Y^j$);
   - in which an encoder (14), which is designed as a neural network, is provided for mapping the HMM prototypes ($X^j$) onto the compressed HMM prototypes ($Y^j$);
   - in which the compressed HMM prototypes ($Y^j$) have components ($Y^j_m$, 16), (m = 1, ..., M);
   - in which the components ($Y^j_m$) are converted by a bit encoder (22) into binary numbers ($Yq^j_m$, 23), (j = 1, ..., J), (m = 1, ..., M);
   - in which a neural network (18) is provided for mapping the compressed HMM prototypes ($Y^j$) onto reconstructed HMM prototypes ($X'^j$);
   - in which the structure and parameters of the neural network (18) are selected in such a way that the neural network can map the binary numbers ($Yq^j_m$, 23) onto the reconstructed HMM prototypes ($X'^j_k$);
   - in which the structure and parameters of the neural network (14), of the bit encoder (22) and of the neural network (18) are selected in such a way that the binary numbers ($Yq^j m$, 23) consist of as few bits as possible; and
   - in which the neural network (14) and the neural network (18) are selected in such a way that both the spacing between ($X^j$) and ($X'^j$) and also the vector dimension of the compressed HMM prototypes ($Y^j$) are minimized.

2. Method according to at least one of the preceding claims, **characterized in that** the components with the higher ability to discriminate are weighted more heavily in order to determine the spacing between the ($X^j$) and the ($X'^j$).

3. Computer program product which can be stored on a computer-suitable medium and comprises machine-readable programming means which permit a computer to execute the method according to one of Claims 1 to 2.

4. Data medium on which there is stored a computer program which permits a computer to carry out the method according to one of Claims 1 to 2 by means of a loading process.

5. Arrangement **characterized in that** it is set up to execute a method according to one of Claims 1 to 2.

**Revendications**

1. Procédé de compression de prototypes HMM,

   - des prototypes HMM ($X^j$) étant donnés;
   - les prototypes HMM ($X^j$) étant appliqués sur des prototypes HMM comprimés ($Y^j$);
   - un codeur (14), qui est réalisé en tant que réseau neuronal, étant prévu pour appliquer les prototypes HMM ($X^j$) sur les prototypes HMM comprimés ($Y^j$);
   - les prototypes HMM comprimés ($Y^j$) ayant des composantes ($Y^j_m$, 16) avec (m = 1, ..., M);
   - les composantes ($Y^j_m$) étant converties par un codeur de bits (22) en nombres binaires ($Yq^j_m$, 23) avec (j = 1, ..., J), (m = 1, ..., M);
   - un réseau neuronal (18) pour appliquer les prototypes HMM comprimés ($Y^j$) sur des prototypes HMM reconstruits ($X'^j$) étant prévu;
   - la structure et les paramètres du réseau neuronal (18) étant choisis tels que le réseau neuronal peut appliquer les nombres binaires ($Yq^j_m$, 23) sur les prototypes HMM reconstruits ($X'^j_k$);
   - la structure et les paramètres du réseau neuronal (14), du codeur de bits (22) et du réseau neuronal (18) étant choisis tels que les nombres binaires ($Yq^j_m$, 23) se composent d'aussi peu de bits que possible et
   - le réseau neuronal (14) et le réseau neuronal (18) étant choisis tels que non seulement l'écart entre ($X^j$) et ($X'^j$), mais aussi la dimension vectorielle des prototypes HMM comprimés ($Y^j$) sont minimisés.

2. Procédé selon au moins l'une des revendications précédentes, **caractérisé en ce que**, pour déterminer l'écart entre les ($X^j$) et les ($X'^j$), les composantes avec la capacité de discrimination plus élevée sont pondérées plus fortement.

3. Produit de programme informatique qui est stockable sur un support approprié pour un ordinateur et comprend des moyens de programme lisibles par un ordinateur, lesquels permettent à un ordinateur d'exécuter le procédé selon l'une des revendications 1 à 2.

4. Support de données sur lequel est stocké un programme informatique qui permet à un ordinateur d'exécuter le procédé selon l'une des revendications 1 à 2 par un processus de chargement.

5. Dispositif, **caractérisé en ce qu'**il est aménagé pour exécuter un procédé selon l'une des revendications 1 à 2.

# FIG 1

# FIG 2

# FIG 3

26

28

30

NN — 18

Y$^1$, Y$^2$, ..., YM — 24